(19) Europäisches Patentamt

European Patent Office

Office européen des brevets

(11) Veröffentlichungsnummer : **0 042 116**
**B1**

(12) EUROPÄISCHE PATENTSCHRIFT

(45) Veröffentlichungstag der Patentschrift :
11.04.84

(21) Anmeldenummer : 81104324.9

(22) Anmeldetag : 04.06.81

(51) Int. Cl.³ : **H 03 H 19/00**

(54) Elektrische Filterschaltung zur Verarbeitung analoger Abtastsignale.

(30) Priorität : 13.06.80 DE 3022252

(43) Veröffentlichungstag der Anmeldung :
23.12.81 Patentblatt 81/51

(45) Bekanntmachung des Hinweises auf die Patenterteilung : 11.04.84 Patentblatt 84/15

(84) Benannte Vertragsstaaten :
AT BE CH FR GB IT LI NL SE

(56) Entgegenhaltungen :
ARCHIV FÜR ELEKTRONIK & ÜBERTRAGUNGS-
TECHNIK, Band 34, Heft 3, März 1980, STUTTGART
(DE) J.A. MOSSEK et al.: "Entwurf von Schalter-Kon-
densator-Filtern mit Hilfe der bilinearen Transformation", Seiten 118-124
ELECTRONICS LETTERS, Band 15, Heft 13, 21. Juni
1979, LONDON (GB) K. MARTIN et al.: "Strays-Insensitive switched capacitor Filters Based on Bilinear Z-
Transform", Seiten 365-366
IEEE JOURNAL OF SOLID-STATE CIRCUITS, Band
SC-15, Heft 6, Dezember 1980, NEW YORK (US) P.W.
BOSSHART: "A Multiplexed Switched Capacitor Filter
Bank", Seiten 939-945
ELECTRONICS LETTERS, Band 15, Heft 3, 1. Februar
1979, LONDON (GB) G.C. TEMES et al.: "Switched-
Capacitor circuits Bilinearly Equivalent to Floating
Inductor or F.D.N.R., Seiten 87 und 88

(73) Patentinhaber : **SIEMENS AKTIENGESELLSCHAFT**
**Berlin und München Wittelsbacherplatz 2**
**D-8000 München 2 (DE)**

(72) Erfinder : **Nossek, Josef, Dipl.-Ing.,**
**Noestrasse 30**
**D-8000 München 71 (DE)** .

### Elektrische Filterschaltung zur Verarbeitung analoger Abtastsignale

Die Erfindung betrifft eine elektrische Filterschaltung zur Verarbeitung analoger Abtastsignale, bestehend aus zu vorgegebenen Taktphasen gesteuerten Schaltern, aus Kondensatoren und aus wenigstens einem Operationsverstärker, dessen nichtinvertierender Eingang auf ein Bezugspotential, insbesondere Massepotential, gelegt ist, bei der die Einkopplung der Signalladungen über wenigstens einen Kondensator erfolgt, dem gesteuerte Schalter zugeordnet sind und der dem invertierenden Eingang des Operationsverstärkers vorgeschaltet ist, und bei der weiterhin dem Ausgang des Operationsverstärkers wenigtens ein gesteuerter Schalter nachgeschaltet ist.

Schalterfilter der vorgenannten Art sind für sich bereits durch den Aufsatz « Switched-Capacitor Filter Design Using the Bilinear z-Transform » in der Zeitschrift « IEEE Transactions on Circuits and Systems », Vol CAS-25, Nr. 12, Dez. 1978, Seiten 1039 bis 1044 und auch durch die Arbeit « Switched-Capacitor Circuits Bilinearly Equivalent to Floating Inductor or F.D.N.R. » in der Zeitschrift Electronics Letters, 1. Febr. 1979, Vol 15, Nr. 3, Seiten 87 und 88, bekannt geworden. Es handelt sich dabei um solche Filter, die nicht zeitkontinuierliche Analogsignale im eigentlichen Sinne verarbeiten, sondern zeitdiskrete Signale, die in Form von Abtastproben vorliegen, wobei die Abtastproben im Rhytmus einer Abtastfrequenz F erzeugt werden und über die Beziehung $T = 1/F$ wird dementsprechend T die Abtastperiode genannt. Schaltungen zur Erzeugung solcher Abtastproben sind für sich bekannt, so daß sie an dieser Stelle nicht im einzelnen erläutert werden müssen. Es ist jedoch auch im folgenden davon auszugehen, daß den dargestellten Schaltungen solche Abtastschaltungen jeweils vor- bzw. nachgeschaltet sein können, so daß es also einerseits gelingt, aus einem Analogsignal entnommene Abtastproben der Filterschaltung eingangsseitig zuzuführen und die ausgangsseitig zur Verfügung stehenden Signale wieder in zeitkontinuierliche Analogsignale umzuwandeln. Der wesentliche technische Vorteil solcher Filter ist darin zu sehen, daß Spulen durch aktive Schaltelemente und Kondensatoren nachgebildet werden, so daß sie sich zur monolithischen Integration von größeren Filterschaltungen eignen. Als Verstärker werden danei überwiegend die bekannten Operationsverstärker eingesetzt und es wird dabei angestrebt, einerseits eine möglichst geringe Anzahl von Schaltelementen anwenden zu müssen und andererseits auch die Stabilität solcher Schaltungen zu gewährleisten. Bei den vorerwähnten bekannten Schaltungen wird ebenfalls der invertierende Eingang mit dem Ausgang eines Operationsverstärkers über einen Kondensator verbunden, also gewissermaßen gegengekoppelt. Jedoch zeigt sich, daß die zum Einsatz kommenden Operationsverstärker eine hohe Gleichtaktunterdrückung benötigen, da der nicht invertierende Eingang des Operationsverstärkers nicht stets auf Massepotential gehalten wird. Weiterhin erfolgt die Realisierung der Kondensatoren in der Art der MOS-Technologie (Metalloxydsilizium-Technologie) und es zeigt sich, daß bei diesen Realisierungsverfahren die unvermeidlichen mit jedem schwebenden MOS-Kondensator verbundenen Erdkapazitäten zu erheblichen Störungen der Filterfunktion führen können.

Es sei in diesem Zusammenhang noch darauf hingewiesen, daß auch Realisierungsmöglichkeiten für die in solchen Filtern zur Anwendung kommenden Schalter für sich bekannt sind. Man wird selbstverständlich bestrebt sein, auch die Schalter so auszubilden, daß sie einem Integrationsprozeß zusammen mit den übrigen Filterstrukturen zugänglich sind. Zu denken ist hierbei insbesondere an MOS-Transistoren. Im folgenden ist dies nicht mehr im einzelnen dargestellt, sondern es wird davon ausgegangen, daß beispielsweise durch Anlegen einer Steuerspannung an die Steuerelektroden der Schalter durchlässig wird, d. h., also daß der Schalter in diesem Zeitraum schließt, während er in den übrigen Zeitabschnitten nicht durchgeschaltet und somit eine elektrische Unterbrechung darstellt.

Der Erfindung liegt die Aufgabe zugrunde, als Schalterkondensator-Anordnungen ausgebildete Schaltungsstrukturen anzugeben, die ein resonanzfähiges Verhalten zeigen, und die somit allgemein in Filterschaltungen der elektrischen Nachrichtentechnik verwendbar sind.

Ausgehend von den einleitend genannten Schaltungen, wird diese Aufgabe gemäß der Erfindung dadurch gelöst, daß die Schalter derart angeordnet und gesteuert sind, daß eine aus N + 1 Kondensatoren gebildete, in sich geschlossene Leiterschleife entsteht, bei der jeder der N + 1 Kondensatoren während einer Taktphase seine Ladung abgibt und in der unmittelbar darauffolgenden Taktphase Ladung aufnimmt, derart, daß N Signalladungen zyklisch umlaufen, wobei die eine geschlossene Leiterschleife bildenden N + 1 Kondensatoren mit einer Elektrode mit dem invertierenden Eingang des Operationsverstärkers verbunden sind und mit ihrer anderen Elektrode jeweils über einen Schalter mit Bezugspotential und jeweils über einen weiteren Schalter mit dem Ausgang des Operationsverstärkers verbunden sind.

In den Unteransprüchen sind weitere vorteilhafte Ausgestaltungen angegeben.

Anhand eines Ausführungsbeispieles wird nachstehend die Erfindung hoch näher erläutert.

Es zeigen in der Zeichnung

Figur 1 eine Schaltungsstruktur für ein erfindungsgemäßes Filter das mit vier Taktphasen zu betreiben ist ;

Figur 2 das zur Schaltung nach Fig. 1 gehörende Taktschema, in dem t die Zeitvariable und T die Taktperiode bedeuten ; die Taktphasen, in denen die einzelnen Schalter schließen, sind mit den Bezugszeichen 1, 2, 3, 4, bezeichnet und es ist auch erkennbar, daß sich die einzelnen Schließungsdauern nicht überlappen.

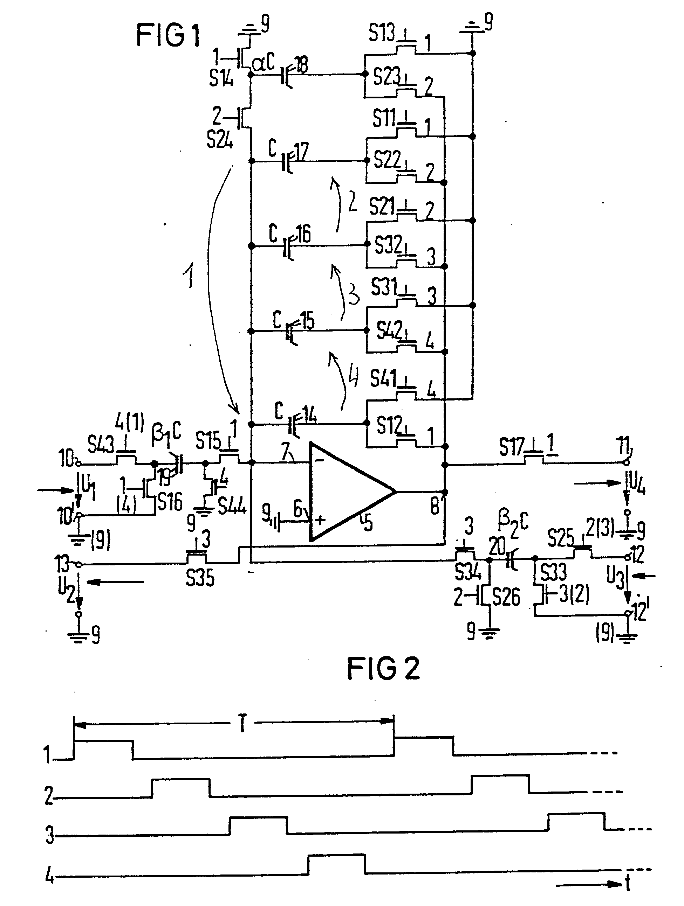

Im Ausführungsbeispiel von Figur 1 sind die einzelnen Schalter mit S und einer zweistelligen Zahl bezeichnet und nurmehr durch ihr Schaltsymbol dargestellt. Unmittelbar an den Schaltern ist auch die Taktphase (vergleiche Figur 2) angegeben, in denen die Schalter geschlossen sind und es ist weiterhin zu erkennen, daß die erste Zahl übereinstimmt mit der Taktphase in der die Schalter geschlossen sind, während die zweite Zahl eine Ordnungszahl darstellt.

In Figur 1 ist nun zu erkennen ein Operationsverstärker 5, dessen nichtinvertierender Eingang (+) mit der Bezugsziffer 6 bezeichnet ist und es ist dieser Eingang unmittelbar mit Bezugspotential verbunden. Der nichtinvertierende Eingang (−) des Operationsverstärkers 5 ist mit der Bezugsziffer 7 bezeichnet, sein Ausgang mit der Bezugsziffer 8. Vom invertierenden Eingang 7 führt eine Leitung auf Bezugspotential 9 und es ist diese Leitung durch die Schalter S24 und S14 gesteuert die im Ausführungsbeispiel während der Taktphasen 1 bzw. 2 geschlossen sind. An diese Leitung sind nun einerseits die Kondensatoren 14 bis 17 angeschaltet, deren Kapazitätswert mit C bezeichnet ist. Die zweite Elektrode der Kondensatoren 14 bis 17 ist über die Schalter S11, S21, S31 und S41 mit Bezugspotential 9 verbunden und es ist zu erkennen ; daß diese Schalter während der Taktphasen 1 bzw. 2 bzw. 3 bzw. 4 schließen. Weiterhin ist die zweite Elektrode der Kondensatoren 14 bis 17 über die Schalter S12, S22, S32, S42 mit dem Ausgang 8 des Operationsverstärkers 5 verbunden und es schließen diese Schalter währen der Taktphasen 1 bzw. 2 bzw. 3 bzw. 4. In Verbindung mit dem Taktplan nach Figur 2 ist also der Schaltung von Figur 1 zu entnehmen, daß von den Kondensatoren 14 bis 17 jeweils nur einer, z. B. 15, mit dem Ausgang 8 des Operationsverstärkers 5 verbunden ist, während jeweils nur einer, z. B. der Kondensator 14, mit Bezugspotential 9 verbunden ist. Weiterhin erfolgt die Steuerung derart, daß innerhalb einer Abtastperiode T jeder der vier Kondensatoren 14, 15, 16 und 17 während einer der vier Taktphasen 1 bis 4 mit Bezugspotential 9 und in der unmittelbar darauf folgenden Taktphase mit dem Ausgang 8 des Operationsverstärkers verbunden ist. Wenn im Beispiel die Verbindung mit Bezugspotential 9 während der Taktphase 1 erfolgt, dann muß entsprechend diese Verbindung mit dem Ausgang 8 des Operationsverstärkers in der darauf folgenden Taktphase 2 erfolgen.

Im Ausführungsbeispiel von Figur 1 sind somit vier Kondensatoren verwendet, die in der Wirkungsweise eine in sich geschlossene Leiterschleife bilden, was in Fig. 1 zusätzlich durch die mit den zugehörigen Taktphasen 1, 2, 3, 4 bezeichneten Pfeile dargestellt ist. Dabei sind die Schalter und der zugehörige Taktplan derart eingeschaltet bzw. gewählt, daß drei Signalladungen zyklisch umlaufen. Drückt man dies allgemein aus, dann können N Signalladungen zyklisch umlaufen, wenn N+1 Kondensatoren verwendet werden und in entsprechender Erweiterung des vorstehend kenntlich gemachten Gesetzes eine in sich geschlossene Leiterschleife bilden.

Wie bereits erwähnt, ist in Figur 1 eine vorteilhafte Ausgestaltung insofern dargestellt ist, als zur Bedämpfung der Eigenschwingung ein weiterer Kondensator 18 verwendet ist, dessen Kapazitätswert unmittelbar in der Zeichnung mit $\alpha C$ angegeben ist. Der Kondensator 18 ist nämlich in der Lage, der in sich geschlossenen Leiterschleife Ladung zu entnehmen, und zwar läßt sich dies über den Wert $\alpha$ einstellen. Hierzu ist es lediglich erforderlich, den Kondensator 18 während einer der $N+1$ Taktphasen, z. B. während der Taktphase 2 mit dem Ausgang 8 des Operationsverstärkers zu verbinden, so daß also im Beispiel der Kondensator 17 über die Schalter S23 und S24 dem Kondensator 18 parallel geschaltet ist. Der Kondensator 18 kann dann zu einer beliebigen anderen Taktphase entladen werden, was im Ausführungsbeispiel über die Schalter S13 und S14 erfolgt, die den Kondensator während der Taktphase 1 an Bezugspotential 9 legen. Für diesen Vorgang können an sich auch mehrere Schaltungsvarianten angewendet werden, jedoch ist zur Erzielung einer möglichst guten Entladung im Ausführungsbeispiel von Figur 1 der Schaltungsvorgang so gewählt, daß beide Elektroden des Kondensators 18 in der Taktphase 1 auf Bezugspotential 9 liegen.

Wie bereits erwähnt, ist die angegebene Schaltung geeignet, analoge Abtatsignale zu verarbeiten. Es müssen deshalb auch Einkoppelschaltungen und auch Auskoppelschaltungen vorgesehen werden, die geeignet sind, die in Form von Abtastproben zur Verfügung stehenden Signalladungen der Schaltung zuzuführen bzw. am Ausgang der Schaltung als gefiltertes Signal zur Verfügung zu stellen. Zur Einkopplung der Signalspannung ist im Ausführungsbeispiel von Figur 1 zunächst ein Kondensator 19 vorgesehen, dessen Kapazitätswert dort mit $\beta_1 C$ bezeichnet ist. Für die Schalter-Ein- und Auskoppelschaltungen ist im folgenden zu berücksichtigen, daß ihre Schaltfolge bzw. ihre Zuordnung zur Schaltfolge der bereits beschriebenen Schaltung abgestellt ist auf das Ausführungsbeispiel, das ja auf vier Takphasen ausgelegt ist. Es sind auch in den Ein- und Auskoppelschaltungen an die einzelnen Schalter unmittelbar die Schaltphasen angeschrieben, so daß deren Schließungsdauer unmittelbar ablesbar ist auch hier gilt, daß die den Schaltern S zugeordneten Zahlen als zweistellige Zahl ausgebildet sind, deren erste Stelle die Schließungsdauer während der zugehörigen Taktphase angibt während die zweite Stelle eine Ordnungszahl darstellt. Auch sind verschiedentlich weitere mögliche Taktphasen in Klammern angegeben, in denen die Schalter ebenfalls geschlossen werden können, ohne daß dabei die Funktionstüchtigkeit der Schaltung verloren geht.

In Figur 1 ist ein erstes Eingangsklemmenpaar mit den Bezugszeichen 10 und 10' versehen und es liegt dort die Eingangssignalprobe $U_1$. Der Eingangsklemme 10 folgt ein Schalter S43, der in den Taktphasen 4 bzw. 1 geschlossen sein kann, und dem im Querzweig ein Schalter S16 folgt, der in den Schaltphasen 1 bzw. 4 geschlossen sein kann und der zur zweiten, auf Bezugspotential 9 oder einem anderen Potential liegenden Eingangsklemme 10' führt. Es folgt darauf der bereits erwähnte Kondensator 19, dem im Querzweig der Schalter S44 nachgeschaltet ist, der auf der dem Kondensator 19 abgewandte Seite ebenfalls auf Bezugspotential liegt. Im Längszweig folgt der Schalter S15, der während der Taktphase 1 schließt und der ausgangsseitig unmittelbar an den invertierenden Eingang 7 des Operationsverstärkers 5 angeschaltet ist. Für die Auskopplung der Signale kann im einfachsten Fall der während der Taktphase 1 schliessende Schalter S17 vorgesehen werden, über den unmittelbar die Ausgangsklemme 11 erreicht wird, so daß also zwischen der Ausgangsklemme 11 und Bezugspotential 9 während der Taktphase 1 das Ausgangssignal $U_4$ zur Verfügung steht.

Auch besteht die Möglichkeit, den Ausgang 8 des Operationsverstärkers 5 während der Taktphase 3 über den Schalter S35 mit einem weiteren Ausgangsklemmenpaar 13 bzw. 9 als Bezugspotential zu verbinden, so daß dort in der Taktphase 3 das Ausgangssignal $U_2$ zur Verfügung steht.

Figur 1 läßt erkennen, daß dort ein weiteres Eingangsklemmenpaar 12, 12' vorgesehen ist von denen die Klemme 12' ebenfalls auf Bezugspotential 9 liegt, so daß also zwischen den Klemmen 12 und 12' eine Eingangsspannung $U_3$ liegt. Der Klemme 12 folgt ein Schalter S25, der während der Taktphase 2 bzw. während der Taktphase 3 schließt. Dem Schalter S25 ist. in Eingangsrichtung betrachtet, im Querzweig ein weiterer Schalter S33 nachgeschaltet, der entsprechend während der Taktphasen 3 bzw. 2 schließt. Darauf folgt ein Kondensator 20, dessen Kapazität mit $\beta_2 C$ bezeichnet ist und dessen der Eingangsklemme 12 abgewandte Elektrode über den Schalter S26, der zur Taktphase 2 schließt, mit Bezugspotential 9 verbunden ist. Der sich daran anschließende Längszweig wird während der Taktphase 3 über den Schalter S34 schließlich mit dem invertierenden Eingang 7 des Operationsverstärkers 5 verbunden.

Für die physikalische Wirkungsweise sei noch auf folgendes hingewiesen. Bei der anhand der Figuren 1 und 2 beschriebenen Schaltung werden Ladungspakete tatsächlich weitergeschoben. Zur Verwirklichung eines Resonators mit der Resonanzfrequenz $f_{res} = F/N$ werden $N + 1$ gleich große Kondensatoren und ein $(n + 1)$-Phasen-Takt benötigt. Eine gesonderte Löschphase ist nicht erforderlich, da die Kondensatoren ja bei der Abgabe der gespeicherten Ladung vollständig entleert werden — idealer Operationsverstärker vorausgesetzt — und damit zur Aufnahme eines neuen Ladungspaketes bereit sind.

Eine Abweichung der einzelnen Kapazitätswerte vom gemeinsamen Nominalwert bewirkt jetzt nur unterschiedliche Spannungswerte an den Kondensatoren, bleibt aber ohne Einfluß auf die Größe der Ladungspakete.

Fig. 1 zeigt einen solchen absolut stabilen Resonator mit $f_{res} = F/3$ und den zugehörigen 4-Phasentakt. Der Kondensator $\alpha C$ dient der vom Gesamtfilter her erforderlichen Bedämpfung des Resonators. Gleichzeitig ist eine Möglichkeit der Signal- Ein- bzw. Auskopplung dargestellt, die den Resonator zu einem Viertor ausbildet, mit dem hin- und rücklaufende Wellen an Ein- und Ausgang eines Leitungsresonators nachgebildet werden können.

Zur Darstellung der Übertragungsfunktionen kann die sogenannte, an sich bekannte z-Transformation (IEEE-Transactions on Circuits an Systems, Vol CAS-25, Nr. 12, Dez. 1978, Seite 1039 bis 1044, Electronics Letters, 1. Febr. 1979, Vol. 15, Nr. 3, Seiten 87, 55,) herangezogen werden. In dieser Darstellungsweise ergibt sich dann folgendes.

Das Nennerpolynom sämtlicher Übertragungsfunktionen dieses Mehrtores läutet

$$N(z) = 1 - z^{-3(1 \cdot 1 + \alpha)}$$

d. h. die Eigenfrequenzen liegen in der z-Ebene auf einem Kreis mit dem Radius $1/^3\sqrt{1 + \alpha}$. Die Zählerpolynome sind vom Typ

$$N(z) = \pm \beta_{1,2} z^{-k} \quad k = 0,1,2,3.$$

In den Lücken zwichen den einzelnen Taktphasen ist der Operationsverstärker nicht gegengekoppelt, so daß die Gefahr der Sättigung besteht («latch up»-Effekt). D. h. diese Lücken sollen hinreichend kurz sein, um einen Übergang des Operationsverstärkers in den Sättigungszustand zu verhindern. Bei der Verwendung von sogenannten dynamischen Verstärkern tritt dieses Problem nicht auf, da der Operationsverstärker am Ende des jeweiligen Umladevorganges stromlos ist.

Mit der angegebenen Schaltung lassen sich monolithisch integrierbare Resonatoren mit taktgenauen Resonanzfrequenzen herstellen. Die beschriebene Schaltung hat den Vorteil, daß für den einzelnen Schalter — Kondensatorresonator jeweils nur ein Operationsverstärker benötigt wird und die Kondensatoren in der geschlossenen Leiterschleife unter sich gleich groß sind. Darüberhinaus ist der angegebene Resonator stabil und stellt das Ausgangssignal entkoppelt zur Verfügung.

**Ansprüche**

1. Elektrische Filterschaltung zur Verarbeitung analoger Abtastsignale, bestehend aus zu vorgegebenen Taktphasen (1, 2, 3, 4) gesteuerten Schaltern, aus Kondensatoren und aus wenigstens einem Operationsverstärker (5), dessen nichtinvertierender Eingang (7) auf ein Bezugspotential, insbesondere Massepotential, (9) gelegt ist, bei der die Einkopplung der Signalladungen über wenigstens einen Kondensator (C) erfolgt, dem gesteuerte Schalter zugeordnet sind und der dem invertierenden Eingang (7) des Operationsverstärkers (5) vorgeschaltet ist, und bei der weiterhin dem Ausgang (8) des Operationsverstärkers (5) wenigstens ein gesteuerter Schalter (S17) nachgeschaltet ist, dadurch gekennzeichnet, daß die Schalter derart angeordnet und gesteuert sind, daß eine aus N + 1 (N = 2, 3, 4, ...) Kondensatoren (14, 15, 16, 17) gebildete, in sich geschlossene Leiterschleife entsteht, bei der jeder N + 1 Kondensatoren (z. B. 17) während einer Taktphase (z. B. 1) seine Ladung abgibt und in der unmittelbar darauffolgenden Taktphase (z. B. 2) Ladung aufnimmt, derart, daß N Signalladungen zyklisch umlaufen, wobei die eine geschlossene Leiterschleife bildenden N + 1 Kondensatoren (14, 15, 16, 17) mit einer Elektrode mit dem invertierenden Eingang (7) des Operationsverstärkers (5) verbunden sind und mit ihrer anderen Elektrode jeweils über einen Schalter (S11, S21, S31, S41) mit Bezugspotential (9) und jeweils über einen weiteren Schalter (S12, S22, S32, S42) mit dem Ausgang (8) des Operationsverstärkers (5) verbunden sind.

2. Elektrische Filterschaltung nach Anspruch 1, dadurch gekennzeichnet, daß der in sich geschlossenen Leiterschleife (14, 15, 16, 17) ein weiterer, über Schalter (S23, S24 ; S13, S14) gesteuerter Kondensator (18) zugeordnet ist, der während einer Taktphase (z. B. 2) aus der Leiterschleife (14, 15, 16, 17) Ladung entnimmt.

3. Elektrische Filterschaltung nach Anspruch 1 oder 2, dadurch gekennzeichnet, daß die weiteren Schalter (S12, S22, S32, S42) von N + 1 Taktphasen (1 bis 4) derart gesteuert sind, daß jeweils nur einer (z. B. 14) der N + 1 Kondensatoren mit Bezugspotential (9) verbunden ist und jeweils nur einer (z. B. 15) mit dem Ausgang (8) des Operationsverstärkers (5) verbunden ist, und daß weiterhin die Steuerung der Schalter derart erfolgt, daß innerhalb einer Abtastperiode (T) jeder der N + 1 Kondensator (14, 15, 16, 17) während einer der N + 1 Taktphasen (1 bis 4 ; z. B. 1) mit Bezugspotential (9) und in der unmittelbar darauffolgenden Taktphase (z. B. 2) mit dem Ausgang (8) des Operationsverstärkers (5) verbunden ist.

4. Elektrische Filterschaltung nach einem der Ansprüche 2 oder 3, dadurch gekennzeichnet, daß der Ladung entnehmende Kondensator (18) während einer der N + 1 Taktphasen (z. B. 2) dem während dieser Taktphase am Ausgang (8) des Operationsverstärkers (5) liegenden Kondensator (z. B. 17) über zwei Schalter (S23, S24) parallel geschaltet ist, und zu einer beliebigen anderen Taktphase (z. B. 1) über Schalter (S13, S14) entladen wird.

5. Elektrische Filterschaltung nach Anspruch 4, dadurch gekennzeichnet, daß die Entladung durch Anschalten beider Elektroden des Kondensators (18) an Bezugspotential (9) erfolgt.

6. Elektrische Filterschaltung nach einem der vorhergehenden Ansprüche, dadurch gekennzeichnet, daß die die Einkopplung der Signalladung bewirkenden Kondensatoren (19, 20) mit einer Elektrode über gesteuerte Schalter (S43, S16 ; S25, S33) zwischen Eingangsklemmen (10, 10', 12, 12') umgeschaltet werden, während ihre andere Elektrode über gesteuerte Schalter (S15, S44 ; S34, S26) zwischen dem invertierenden Eingang (7) des Operationsverstärkers (5) und Bezugspotential (9) umgeschaltet wird, und daß die Ausgangsklemmen (11, 13) über gesteuerte Schalter (S17, S35) mit dem Ausgang (8) des Operationsverstärkers (5) verbunden sind.

## Claims

1. An electrical filter circuit for processing analogue sampling signals, having switches controlled in accordance with predetermined clock pulse phases (1, 2, 3, 4), and of capacitors and at least one operational amplifier (5), whose noninverting input (7) is connected to a reference potential, in particular earth potential (9), wherein the input coupling of the signal charges takes place via at least one capacitor (C), to which controlled switches are assigned and wich is connected preceding the inverting input (7) of the operational amplifier (5), and wherein furthermore at least one controlled switch (S17) is connected following the output (8) of the operational amplifier (5), characterised in that the switches are so arranged and controlled that a closed conducted loop is produced from N + 1 (N = 2, 3, 4, ...) capacitors (14, 15, 16, 17) and wherein each of the N + 1 capacitors (e. g. 17) emits its charge during a clock pulse phase (e. g. 1) and receives a charge during the directly following clock pulse phase (e. g. 2) in such a manner that N signal charges circulate cyclically, where the N + 1 capacitors (14, 15, 16, 17) forming a closed conductor loop have one electrode connected to the inverting input (7) of the operational amplifier (5) and have their other electrode respectively connected to reference potential (9) via a switch (S11, S21, S31, S41) and to the output (8) of the operational amplifier (5) by means of a further switch (S12, S22, S32, S42).

2. An electrical filter circuit as claimed in Claim 1, characterised in that the closed conductor loop (14, 15, 16, 17) is assigned a further capacitor (18) controlled by switches (S23, S24 ; S13, S14) and which removes charge from the conductor loop (14, 15, 16, 17).

3. An electrical filter circuit as claimed in Claim 1 or 2, characterised in that the further switches (S12, S22, S32, S42) are controlled by N + 1 clock pulse phases (1 to 4) in such a manner that only one (e. g. 14) of the N + 1 capacitors is respectively connected to reference potential (9) and only one (e. g. 15) is respectively connected to the output (8) of the operational amplifier (5), and that furthermore the control of the switches is so effected that within a sampling period (T) each of the N + 1 capacitors (14, 15, 16, 17) is connected to reference potential (9) during one of the N + 1 clock pulse phases and is connected to the output (8) of the operational amplifier (5) in the directly following clock pulse phase (e. g. 2).

4. An electrical filter circuit as claimed in one of Claims 2 or 3, characterised in that during one of the N + 1 clock pulse phases (e. g. 2) the charge-removing capacitor (18) is connected parallel to the capacitor (e. g. 17) arranged at the output (8) of the operational amplifier (5) during this clock pulse phase, by two switches (S23, S24) and is discharged by means of switches (S13, S14) during any other clock pulse phase (e. g. 1).

5. An electrical filter circuit as claimed in Claim 4, characterised in that the discharge is carried out by connecting both electrodes of the capacitors (18) to reference potential (9).

6. An electrical filter circuit as claimed in one of the preceding Claims, characterised in that the capacitors (19, 20) which effect the input coupling of the signal charge have one electrode switched over via controlled switches (S43, S16 ; S25, S33) between input terminals (10, 10', 12, 12') whereas their other electrode is switched over via controlled switches (S15, S44 ; S34, S26) between the inverting input (7) of the operational amplifier (5) and reference potential (9), and that the output terminals (11, 13) are connected to the output (8) of the operational amplifier (5) by controlled switches (S17, S25).

**Revendications**

1. Circuit de filtre électrique pour le traitement de signaux analogiques d'échantillonnage, constitué par des interrupteurs commandés à des phases de cadence (1, 2, 3, 4) prédéterminées, par des condensateurs et par au moins un amplificateur opérationnel (5) dont l'entrée non inverseuse (7) est portée à un potentiel de référence, en particulier au potentiel masse, (9), dans lequel l'introduction des charges des signaux a lieu par l'intermédiaire d'au moins un condensateur (C) auquel sont associés des interrupteurs commandés et qui est monté en amont de l'entrée inverseuse (7) de l'amplificateur opérationnel (5), et dans lequel, en outre, au moins un interrupteur commandé (S17) est monté en aval de la sortie (8) de l'amplificateur opérationnel (5), caractérisé par le fait que les interrupteurs sont disposés et commandés de telle façon qu'il se forme un circuit en boucle fermée constitué par N + 1 (N = 2, 3, 4, ...) condensateurs (14, 15, 16, 17) dans laquelle chacun des N + 1 condensateurs (par exemple 17) émet, pendant une phase de cadence (par exemple 1), sa charge et reçoit une charge pendant la phase de cadence (par exemple 2) immédiatement suivante, de façon que N charges de signaux circulent cycliquement, la réalisation étant telle que les N + 1 condensateurs (14, 15, 16, 17) qui forment une boucle fermée sont reliés par une électrode à l'entrée inverseuse (7) de l'amplificateur opérationnel (5) et par leur autre électrode respectivement et par un interrupteur (S11, S21, S31, S41) au potentiel de référence (9) et, respectivement, par l'intermédiaire d'un autre interrupteur (S12, S22, S32, S42), à la sortie (8) de l'amplificateur opérationnel (5).

2. Circuit de filtre électrique selon la revendication 1, caractérisé par le fait qu'au circuit en boucle fermée sur elle-même (14, 15, 16, 17) est associé un autre condensateur (8), commandé par l'intermédiaire d'interrupteurs (S23, S24 ; S13, S14) et qui prélèvent une charge de la boucle fermée (14, 15, 16, 17) pendant une phase de cadence (par exemple 2).

3. Circuit de filtre électrique selon la revendication 1 ou 2, caractérisé par le fait que les autres interrupteurs (S12, S22, S32, S42) sont commandés par N + 1 phases de cadence (1 à 4) de telle manière que respectivement un seul (par exemple 14) des N + 1 condensateurs est relié au potentiel de référence (9) et, respectivement un seul (par exemple 15) est relié à la sortie (8) de l'amplificateur opérationnel (5), et qu'en outre la commande des interrupteurs a lieu de telle façon que pendant une période d'échantillonnage (T) chacun des N + 1 condensateurs (14, 15, 16, 17) est relié, pendant l'une des N + 1 phases de cadence (1 à 4, par exemple 1) au potentiel de référence (9) et, dans la phase de cadence immédiatement suivante (par exemple 2), à la sortie (8) de l'amplificateur opérationnel (5).

4. Circuit de filtre électrique selon l'une des revendications 2 ou 3, caractérisé par le fait que le condensateur (18) qui prélève la charge est, pendant l'une des N + 1 phases de cadence (par exemple 2), monté en parallèle, par l'intermédiaire de deux interrupteurs (S23, S24), sur le condensateur (par exemple 17) qui est relié, pendant cette phase de cadence, à la sortie (8) de l'amplificateur opérationnel (5), et que pendant une quelconque autre phase de cadence (par exemple 1) il est déchargé par l'intermédiaire d'interrupteurs (S13, S14).

5. Circuit de filtre électrique selon la revendication 4, caractérisé par le fait que la décharge a lieu par le branchement des deux électrodes du condensateur (18) au potentiel de référence (9).

6. Circuit de filtre électrique selon l'une des revendications précédentes, caractérisé par le fait que les condensateurs (19, 20) qui provoquent l'introduction de la charge de signal, sont commutés en sens inverse entre les bornes d'entrée (10, 10', 12, 12'), avec une électrode, et par l'intermédiaire d'interrupteurs commandés (S43, S16 ; S25, S33), alors que leur autre électrode est commutée dans le sens opposé, par l'intermédiaire d'interrupteurs commandés (S15, S44 ; S34, S26), entre l'entrée inverseuse (7) de l'amplificateur opérationnel (5) et le potentiel de référence (9), et que les bornes de sortie (11, 13) sont reliées, par l'intermédiaire d'interrupteurs commandés (S17, S35), à la sortie (8) de l'amplificateur opérationnel (5).

FIG 1

FIG 2